# EUROPEAN PATENT SPECIFICATION

(11) **EP 1 599 282 B1**
(45) Date of publication and mention of the grant of the patent: **29.07.2009**
(21) Application number: 04718177.1
(22) Date of filing: 05.03.2004
(51) Int. Cl.: B01F 17/00, B01F 17/34, C08G 63/06, C09D 11/00, C09D 11/10, H01B 1/20, B22F 9/00

(54) **USE OF DISPERSIONS IN THE MANUFACTURE OF A MULTI-LAYER CERAMIC CAPACITOR**
VERWENDUNG VON DISPERSIONEN BEI DER HERSTELLUNG EINES VIELLAGIGEN KERAMISCHEN KONDENSATORS
UTILISATION DE DISPERSIONS POUR PRODUIRE UN CONDENSATEUR CERAMIQUE MULTI-COUCHE

(30) Priority: 05.03.2003 GB 0304941
(43) Date of publication of application: 30.11.2005
(73) Proprietor: The Lubrizol Corporation, Wickliffe, Ohio 44092-2298 (US)
(72) Inventor: THETFORD, Dean, Greater Manchester M9 8ZS (GB); SCHOFIELD, John David, Greater Manchester M9 8ZS (GB)
(74) Representative: Weber, Thomas
(86) International application number: PCT/US2004/007345
(87) International publication number: WO 2004/078333

(56) References cited:
- WO-A-00/24503
- WO-A-01/21298
- US-A- 5 753 022
- US-B1- 6 515 061

## Description

### FIELD OF INVENTION

This application discloses the use of a dispersion comprising an electronic particulate solid, a carrier and a dispersant in the manufacture of a multi-layer ceramic capacitor.

### BACKGROUND OF INVENTION

WO-A-94/21368 discloses various dispersants similar to the dispersants taught herein.

US-A-6,515,061 discloses a paste composition having a high thermal conductivity and a relatively low viscosity is used to provide a thermal conductive connection between an electronic component and a cooling device to increase the heat transfer rate between the component and the device cooling the electronic component. The paste composition comprises a non-aqueous dielectric carrier, thermally conductive filler particles and a specially defined dispersant comprising the self-condensation reaction product of a hydroxy fatty acid. A 12-hydroxy stearic acid self condensed reaction product is the preferred dispersant. The pastes are used as a heat transfer means for cooling electronic components.

WO-A-00/24503 discloses a dispersant of formula (1)

T-(A)ₙ(B)ₚ-Z (1)

wherein T is hydrogen or a polymerisation terminating group, A is C₈₋₂₀-linear alkylene or alkenylene, Z is the residue of a polyamine or polyimine preferably with average molecular weight from 500 to 600,000, n is from 2 to 10, p is not less than 2, and the weight ratio of (T-(O-A-CO)ₙ-)-ₚ to Z is from 5:1 to 20:1. The dispersant of formula (1) is particularly useful for dispersing particulate solids in organic media. Compositions comprising a particulate solid and a dispersant of formula (1) are also provided, along with dispersions and millbases comprising a dispersant of formula (1), a particulate solid and an organic medium. The dispersants are used in the preparation of paints, impact printing inks, multimedia tinters, etc.

US-A-5,753,022 discloses a method of preparing a non-aqueous dispersion of a copper phthalocynanine (CuPc) which comprises milling crude CuPc in a high boiling liquid at a temperature from 50 to 150 °C. in the presence of
a) a polyester amine or polyesterammonium salt obtained by the reaction of an amine with a polyhydroxycarboxylic acid of formula (1)

   Y--CO[O--A--CO]ₙ -OH (1)

   wherein
   A is divalent hydrocarbyl;
   Y is hydrogen or optionally substituted hydrocarbyl;
   n is from 1 to 100; and
b) a CuPc fluidizing agent.
The dispersion is especially suitable for direct incorporation into a printing ink.

WO-A-01/21298 discloses a dispersant which comprises a polyamine (e.g. polyallylamine) or polyimine (e.g. polyethyleneimine) backbone chain containing side chains of two or more different types of polyester chain wherein at least one type of polyester chain is derivable from one or more hydroxy carboxylic acids all of which contain a C₁₋₆-alkylene group or lactone thereof such as epsilon -caprolactone and/or delta-valerolactone and at least one other type of polyester chain derivable from one or more hydroxy carboxylic acids wherein at least one of the hydroxy carboxylic acids contains a C₈₋₃₀-alkylene chain (e.g. 12-hydroxystearic acid) or a C₈₋₃₀-alkenylene chain (e.g. ricinoleic acid) or lactone thereof. The dispersant is particularly suitable for preparing mill-bases.

### DETAILED DESCRIPTION OF THE INVENTION

Multi-layer ceramic capacitors are well-known in the art and are generally made by applying a finely divided dielectric material to a substrate and superimposing thereon a layer of finely divided conductive metal such as silver in a desired pattern to serve as capacitor electrode or plate. Multi-layer ceramic capacitors are made from alternating layers of dielectric material and conducting material with the two outermost layers composed of dielectric material. The composite sandwich of alternating layers of dielectric material and conducting material is then fired at the fusing or sintering temperature of the dielectric material, often under pressure, to form a monolithic capacitor structure. During this fusing or sintering process the various components used to uniformly distribute the dielectric material and the conducting material in the different layers are "burnt out". The dielectric layer and the conducting layer are generally prepared from dispersions of dielectric material and conducting material in a carrier, which is generally a non-polar organic liquid. In order to uniformly distribute the electronic particulate solid in the carrier a dispersant is preferably used and this dispersant must be carefully selected in order to avoid separation of the electronic particulate solid in the carrier and to provide for efficient removal during the subsequent firing process.

It has now been found that the use of polyesteramine dispersants derived from ricinoleic acid and polyethyleneimine are particularly effective in dispersing electronic particulate solids in the non-polar organic liquid carriers used in the fabrication of electronic capacitors and that such dispersants may be subsequently removed during a firing process without causing any deleterious effect in the final capacitor.

The present invention relates to the use of a dispersion comprising an electronic particulate solid, a carrier and a dispersant of formula (1)

R-(O-A-CO)ₓ(O-B-CO)_{y}-Z (1)

wherein
R is hydrogen or a polymerisation terminating group;
A is C₈₋₂₀-alkylene and/or C₈₋₂₀-alkenylene;
B is C₁₋₆-alkylene or a lactone thereof;
Z is the residue of a polyamine or polyimine;
x is from 2 to 45;
y is from 0 to 15; and
the ratio of x : y is not less than 3:1,
in the manufacture of a multi-layer ceramic capacitor.

Preferred embodiments of the invention are apparent from the dependent claims.

The polyester chain represented by R - (O - A - CO)ₓ (O - B - CO)_{y} - may be block or preferably random and either moiety represented by (O - A - CO) or (O - B - CO) may be directly attached to R. However, it is preferred that the group (O-A-CO) is attached to R.

Preferably, the ratio of x : y is not less than 5 : 1, more preferably not less than 8 : 1 and especially not less than 10 :1. It is especially preferred that y is zero.

When R is a polymerisation terminating group it is preferably the residue of a carboxylic acid R¹ - COOH wherein R¹ may be aryl, heteroaryl, cycloalkyl or preferably alkyl and may be substituted by halogen, C₁₋₆-alkoxy, amino or ether groups. Preferably R¹ is unsubstituted. When R¹ is alkyl it may be linear or branched, saturated or unsaturated but is preferably saturated.

The total number of carbon atoms in R can be as high as 50 but it is preferred that R contains not less than 8, more preferably not less than 12 and especially not less than 14 carbon atoms. It is also preferred that R contains not greater than 30, more preferably not greater than 24 and especially not greater than 20 carbon atoms.

Examples of carboxylic acids of formula R¹ - COOH are acetic acid, methoxy acetic acid, caproic acid, oleic acid, lauric acid, decanoic acid, dodecanoic acid, stearic acid and palmitic acid. Examples of branched alkyl carboxylic acids are 2-ethylbutyric, 2-ethylhexanoic, 2-butyloctanoic, 2-hexyldecanoic, 2-octyldodecanoic and 2-decyltetra decanoic acids. Branched aliphatic acids are also available under the trademark Isocarb (ex Sasol) and specific examples are Isocarb 12, 16, 20, 28, 32, 34T and 36. Mixtures of carboxylic acids may be used. The unsaturated hydroxy carboxylic acids which are represented by the group (CO - A - O) may contain an alkyl or alkenyl carboxylic acid and this may act as a polymerisation terminating group. This is particularly true where the hydroxy carboxylic acid is derived from natural products.

Preferably, A contains not less than 12 and especially not less than 14 carbon atoms. Examples of hydroxy carboxylic acids from which the group (CO-A-O) may be derived are ricinoleic acid, 12-hydroxy stearic acid, 12-hydroxy dodecanoic acid, 5-hydroxy dodecanoic acid, 5-hydroxy decanoic acid and 4-hydroxy decanoic acid. It is especially preferred that (CO - A - O) is the residue of ricinoleic acid.

The alkylene residue represented by B may be linear or branched. Examples of hydroxy carboxylic acids from which (CO - B - O) is derived are glycolic acid, 6-hydroxy caproic acid and 5-hydroxyvaleric acid.

Examples of lactones are β-propiolactone and optionally alkyl-substituted ε-caprolactone and optionally alkyl-substituted δ-valerolactone. The alkyl substituent is preferably C₁₋₆-alkyl and especially C₁₋₄-alkyl which may be linear or branched. The alkyl substituted ε-caprolactone may be obtained by the oxidation of alkyl substituted cyclohexanone as described in WO-A-98/19784. Examples include 7-methyl-, 3-methyl-, 5-methyl-, 6-methyl-, 4-methyl-, 5-tert.butyl-, 4,6,6-trimethyl- and 4,4,6-trimethyl ε-caprolactone. An example of alkyl substituted valerolactone is β-methly-δ-valerolactone. Preferred lactones are ε-caprolactone and δ-valerolactone.

Mixtures of hydroxy carboxylic acids and lactones may be used.

Preferably, y is not greater than 6, more preferably not greater than 4, even more preferably not greater than 2 and is especially zero.

The weight ratio of the polyester chain R - (O - A - CO)ₓ (O - B CO) - to Z is preferably not less than 5 and especially not less than 8. It is also preferred that the weight ratio of the polyester chain to Z is not greater than 30, more preferably not greater than 20 and especially not greater than 15. Particularly useful dispersants are those wherein the weight ratio of the polyester chain R - (O - A - CO)ₓ (O - B - CO)_{y} - to Z is from 8 to 15.

Z is the residue of a polyamine or polyimine such as polyallyl amine, polyvinyl amine, more preferably poly(C₂₋₄-alkylene imine) (hereinafter PAI) and especially poly(ethylene imine) (hereinafter PEI).

Linear polyethylene imines can be prepared by the hydrolysis of poly(N-acyl) alkylene imines as described by Takeo Saegusa et al in Macromolecular, 1972, Vol 5, page 4470. Branched polyethylene imines of differing molecular weights are available from BASF and Nihon Shokubai. Polyallylamine and poly(N-alkyl) allylamines of differing molecular weights are available from Nitto Bonseki. Polyvinyl amines are available from Mitsubishi Kasei. Poly(propylene imine) dendrimers are available from DSM Fine Chemicals and poly(amido amine) dendrimers are available as "Starburst" dendrimers from Aldrich Chemical Company.

The polyamine or polyimine preferably has a weight-average molecular weight from 500 to 600,000, more preferably from 1,000 to 200,000, even more preferably from 1,000 to 100,000 and especially from 1,000 to 70,000.

The number-average molecular weight of the polyester moiety represented by R - (O - A - CO)ₓ (O - B - CO)_{y} - is preferably from 600 to 4,000 and especially from 800 to 2,000.

The polyester chain moiety represented by R - (O - A - CO)ₓ (O - B - CO)_{y} - may be linked to the polyamine or polyimine component Z by either a covalent amide group - CON= formed between a terminal carbonyl group of the polyester chain and the nitrogen atom of a primary or secondary amine group in the polyamine or polyimine or through a salt linkage - COO-HN⁺= formed between a terminal carboxylic acid group of the polyester chain and an ammonium group in the polyamine or polyimine.

Preferably, the dispersant contains a plurality of polyester chains attached to the polyamine or polyimine and consequently may contain a mixture of amide and salt linkages depending on the severity of the reactor conditions.

The dispersant may also be conveniently represented by general formula 2. 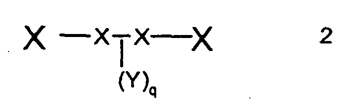 wherein
X - x - x - X represents the polyamine or polyimine;
Y represents the polyester chain moiety R-(O - A - CO)ₓ (O - B - CO)_{y} - ; and
q is from 4 to 2,000.
Preferably q is not less than 10. It is also preferred that q is not greater than 1,000 and especially not greater than 500.

The dispersants may be prepared by any method known to the art and are more typically made by the process described in WO-A-94/21368.

The electronic particulate solid in the dispersion may be any dielectric solid or conducting solid, including mixtures thereof which are used in the fabrication of electronic or electrical devices.

The conducting solid is preferably a metal which may be a powder or flake but is preferably a micronised powder. The particle size of the metal is preferably not greater than 3µm and especially not greater than 1µm. Examples of conducting metals are copper, silver, gold, palladium, platinum, ruthenium, rhodium, osmium, iridium and nickel including mixtures and alloys thereof.

Nickel and silver are preferred metals.

The dielectric solid may be any non-electrically conducting solid and is preferably a metal oxide or inorganic metal derivative containing oxygen. Examples of suitable dielectric solids are glass, barium titanate, lead zirconate, bismuth stannate, titanium dioxide, lead-magnesium niobate, lead oxide, potassium carbonate, magnesium carbonate, lithium carbonate, strontium nitrate, barium-strontium-titanate, bismuth oxide and aluminium oxide and mixtures thereof. Generally, any non-conducting solids may be used which can be fused or sintered to provide a continuous dielectric layer. The particle size of the dielectric solid may be fairly coarse in nature but if it is to be incorporated into the dispersion with the conducting metal the particle size is preferably not greater than 5µm, more preferably not greater than 3µm and especially not greater than 1µm.

The carrier in the dispersion is an organic or preferably a mixture of organic liquids which is also preferably free from water. The organic liquid may be polar or preferably non-polar and is especially a high boiling organic liquid having a boiling point between 150°C and 350°C. Preferably the boiling point is not less than 180°C and especially not less than 200°C. It is also preferred that the boiling point is not greater than 300°C and especially not greater than 280°C.

Preferred high boiling organic liquids are monohydric alcohols such as octanol, decanol, dodecanol, tetradecanol, terpineol (including its stereo isomers) and dialkyleneglycol mono alkyl ethers such as diethylglycol mono alkyl ethers, especially C₁₋₆- monoalkyl ethers for example diethyleneglycol monobutyl ether. Other preferred high boiling organic liquids are esters of dialkylene glycol monoalkyl ethers such as butyl carbitol acetate (2-(2-butoxyethoxy)ethyl acetate).

Terpineol is the preferred high boiling organic liquid.

For ease of handling, the dispersant is preferably made available as a solution in the carrier. Therefore, according to a further aspect of the invention there is provided a composition comprising a high boiling organic liquid having a boiling point between 150°C and 350°C and a dispersant of formula 1.

Preferably the high boiling organic liquid is an aromatic hydrocarbon such as naptha or preferably a mono hydric alcohol and is especially terpineol including isomeric mixtures thereof.

The composition further comprises an electronic particulate solid which is preferably a metal and/or dielectric solid. Preferred metals are silver and nickel. A preferred dielectric solid is barium titanate.

The amount of electronic particulate solid in the composition is preferably from 20% to 90% based on the total amount of the composition. It is also preferred that the amount of electronic particulate solid is not less than 40% and especially not less than 50% based on the total amount of the composition. Particularly useful compositions are those containing from 50 to 70% electronic particulate solid.

The amount of dispersant in the composition can vary over a wide range but it is preferably from 1% to 150% based on the amount of electronic particulate solid. Preferably, the amount of dispersant is not greater than 100%, more preferably not greater than 50% and especially not greater than 20% based on the amount of the electronic particulate solid. Useful dispersions have been found wherein the amount of dispersant is from 2 to 10% by weight of the electronic particulate solid.

The viscosity of the composition may also be adjusted by adding other adjuvants such as a binder resin to adapt the composition for the intended end-use.

Preferably the binder resin is soluble in the carrier. The binder resin is preferably derived from a natural product such as rosin or cellulose. Examples of suitable binder resins are hydrogenated rosin, glycerin esters of hydrogenated rosin, ethyl cellulose and ethyl hydroxy ethyl cellulose.

Thus, when the composition is to be used as a printing ink, especially a screen printing ink for producing electrically conducting tracks in electronic devices, in particular, the capacitors, it is preferable to include a binder resin. The amount of binder resin is preferably from 10% to 40% by weight of the carrier or liquid phase which is equivalent to from 4% to 16% of the total composition by weight.

When the composition is used for fabricating a conducting electrical track using a screen printing technique, it preferably constitutes a viscous ink and especially an ink having a viscosity between 10,000 and 70,000 mPa·s (cps) at 25°C. The ink preferably also contains an inert organic liquid such as an aliphatic hydrocarbon, especially one containing from 6 to 16 carbon atoms. Examples of aliphatic hydrocarbons are gasoline, hexane, heptane, octane, decane, dodecane, hexadecane and especially kerosene. The amount of inert organic liquid in the ink is preferably from 40 to 65% by weight of the paste.

By inert organic liquid is meant any organic liquid which does not interact with the surface of a dielectric substrate, thereby adversely affecting its surface integrity. Preferably, the inert organic liquid has a boiling point from 50° to less than 150°C.

It will also be obvious to those skilled in the art that the viscosity of the ink may be readily varied to render it more suitable for flexographic printing and ink jet printing, such as drop-on-demand ink jet printing.

The ink is generally prepared by dissolving the dispersant and binder resin in the high boiling organic liquid by heating as required. After cooling to 20 - 25°C, the electronic particulate solid such as nickel or silver is added followed by the aliphatic organic liquid, if present. An appropriate dispersion process such as ball milling, bead milling, high-shear mixing or ultrasonication may then be applied. The ink is then applied to a dielectric substrate by any appropriate means known to the industry, such as by screen printing, to produce a precursive electrically conducting track. The inert organic liquid may optionally be removed by evaporating prior to subjecting the dielectric substrate to heating at a temperature from 600 to 1200°C during which process the carrier is burnt out and the electrically conducting particulate solid is fused to give an electrically conducting track on the surface of the dielectric substrate. The thickness of the electrically conducting path may be increased by repeating the screen printing process and/or by applying further material by electro deposition as desired.

The composition may also be used in the manufacture of the capacitors where the composition is applied to either a "green" flexible dielectric body or substrate or a fired rigid dielectric substrate.

The term "green" when applied to a dielectric substrate means a substrate which has not been exposed to high temperature which results in the fusing together or sintering of the dielectric particulate solids which form the dielectric substrate. The green dielectric substrate is often in the form of a self-supporting flexible sheet wherein the dielectric particulate solids are held together by a polymeric organic binder. The green dielectric substrate is printed with the above composition containing a conducting electronic particulate solid (e.g. a metal). The printed dielectric substrate is then cut into sections and the sections arranged in superimposed layers where the conducting printed track projects on the same side for alternate layers and where the top layer is devoid of the printed track. The layers are then compressed under a pressure of 2.07 to 13.8 MPa (300 to 2000 psi) an d then fired at high temperature of 600 - 1200°C to form a monolithic capacitor having projecting electrical contacts.

Where the capacitor contains a relative low number of conducting layers, e.g. two layers, surrounded by dielectric material, the capacitor is known as embedded and such embedded capacitors may also be fabricated using the dispersion according to the invention.

The composition may also be applied to a fired rigid dielectric substrate. However, in this case the composition may contain higher levels of high boiling organic liquid since the fired substrate is much more resistant to such organic liquids compared with a green substrate. When the composition is applied to a fired dielectric substrate it is often beneficial to include up to 20% by weight of the composition of dielectric particulate solid(s) so that after firing the conducting electronic particulate solid forms a conducting body which is held within a fused or sintered body of dielectric material. The fired dielectric material may be in the form of an inorganic chip.

The composition containing the dielectric material may be applied either locally or to the total surface of the substrate. When applied to the total surface the composition may be advantageously applied by doctor blade. When applied locally the composition may be usefully applied as an ink after appropriate adjustment of viscosity.

The invention is now described in further detail with reference to the following examples wherein all references are in parts by weight unless expressed to the contrary.

**Dispersants used in the Examples**

| Dispersant | Polyester chain (PC) | Polyimine (PI) | Ratio of PC:PI |
|---|---|---|---|
| 1 | PHS | SP200 | 10:1 |
| 2 | PRA | SP200 | 10:1 |
| 3 | RA:Cap (4:1) | SP200 | 9:1 |
| 4 | PHS | - | - |
| 5 | PRA | - | - |
| 6 | PRA | - | - |
| 7 | RA:HSA (1:1) | SP200 | 14:1 |
| 8 | PRA | SP200 | 18:1 |
| 9 | PRA | SP200 | 20:1 |
| 10 | PRA | SP050 | 7:1 |

In the above table, PHS is poly (12-hydroxystearic acid), PRA is polyricinoleic acid, RA is ricinoleic acid, cap is ε-caprotactone, HSA is 12-hydroxystearic acid, SP200 is polyethylene imine with a number average molecular weight of 10,000, and SP050 is polyethylene imine with a number average molecular weight of 5000.

The numbers in parenthesis in the polyester chain column for Dispersant 3 indicate the molar ratio of ricinoleic acid to έ-caprolactone in the polyester chain. The numbers in the PC:PI column indicate the weight average ratio of polyester chain to polyethylene imine.

Dispersants 1 to 10 are all made by a similar process to that described in WO-A-94/21368. Dispersant 4 is identical to Polyester A whose preparation is also described in WO-A-94/21368. Dispersants 5 and 6 are made by a similar process to that use in WO-A-94/21368 for Polyester A. Dispersant 5 has a molecular weight of 870. Dispersant 6 has a molecular weight of 1100. Dispersant 7 has a polyester chain of molecular weight of 1600 containing both ricinoleic acid and 12-hydroxystearic acid in a 1:1 mole ratio. Dispersant 8 and 9 has a polyester chain of molecular weight of 1100. Dispersant 10 has a polyester chain of molecular weight of 1600.

### Examples 1 to 12

The dispersant (250 parts) was dissolved in a mixture of Terpineol isomers (250 parts ex Fisher) by stirring together at 120°C under nitrogen for 1 hour. After cooling to 20°C a dispersion was prepared by milling an electronic particulate solid in the solution of dispersant in Terpineol diluted with more Terpineol using a horizontal shaker in the presence of 3mm diameter glass balatini beads (17 parts) for 16 hours. The viscosity of the dispersion was assessed by hand shaking using an arbitrary scale of A to D (good to poor). The results are given in Table 1A below.

**Table 1 A**

| Example | Dispersant | Amount of Dispersant | Ni | BaTiO₃ | Terpineol diluent | Viscosity |
|---|---|---|---|---|---|---|
| 1 | 1 | 0.2 | 7 | - | 2.8 | B/C |
| 2 | 2 | 0.2 | 7 | - | 2.8 | C |
| 3 | 3 | 0.2 | 7 | - | 2.8 | B/C |
| 4 | 4 | 0.2 | 7 | - | 2.8 | B |
| A | - | - | 7 | - | 3.0 | C/D |
| 5 | 1 | 0.2 | - | 5 | 4.8 | A/B |
| 6 | 2 | 0.2 | - | 5 | 4.8 | B |
| 7 | 3 | 0.2 | - | 5 | 4.8 | A/B |
| 8 | 4 | 0.2 | - | 5 | 4.8 | A/B |
| B | - | - | - | 5 | 5 | D |
| 9 | 1 | 0.2 | - | 6 | 3.8 | B/C |
| 10 | 2 | 0.2 | - | 6 | 3.8 | C |
| 11 | 3 | 0.2 | - | 6 | 3.8 | B/C |
| 12 | 4 | 0.2 | - | 6 | 3.8 | B/C |
| 13 | 8 | 0.1 | 7 | - | 2.9 | B/C |
| 14 | 10 | 0.1 | 7 | - | 2.9 | B/C |
| 15 | 7 | 0.1 | 7 | - | 2.9 | B/C |
| 16 | 8 | 0.1 | | 5 | 4.9 | A/B |
| 17 | 10 | 0.1 | | 5 | 4.9 | A/B |
| 18 | 7 | 0.1 | | 5 | 4.9 | A/B |
| 19 | 6 | 0.1 | | 5 | 4.9 | A/B |
| 20 | 9 | 0.1 | | 5 | 4.9 | A/B |
| C | - | 0 | | 5 | 5 | D |

| | | | | | | |
|---|---|---|---|---|---|---|
| Footnote to Table 1: The amount of Dispersant is a 50/50 ^{w}/_{w} mixture of dispersant in a mixture of Isomers of Terpineol. Ni powder is micronised powder ex Aldrich with particle size below 1µm. BaTiO₃ is micronised barium titanate ex Aldrich with particle size below 1µm. | | | | | | |

**Table 1B**

| Example | Dispersant | Amount of Dispersant | Cerium oxide | Terpineol diluent | Viscosity |
|---|---|---|---|---|---|
| D | - | - | 2.5 | 7.5 | B/C |
| 21 | 4 | 0.1 | 2.5 | 7.4 | A/B |
| 22 | 7 | 0.1 | 2.5 | 7.4 | A/B |
| 23 | 3 | 0.2 | 2.5 | 7.3 | A/B |
| 24 | 4 | 0.2 | 2.8 | 7 | B |

| | | | | | |
|---|---|---|---|---|---|
| Cerium oxide is nanosized available from Aldrich. MEL3/Zirconia is available from MEL Chemicals. Okamoor Silica HPF2 is available from Hepworth Minerals & Chemicals. Alumina AE511C is available from Sumitomo. | | | | | |

**Table 1C**

| Example | Dispersant | Amount of Dispersant | MEL Zirconia | Silica | Terpineol diluent | Viscosity |
|---|---|---|---|---|---|---|
| F | - | - | 4 | - | 6 | C |
| 25 | 5 | 0.1 | 4 | - | 5.9 | A/B |
| 26 | 9 | 0.1 | 4 | - | 5.9 | A/B |
| G | - | - | - | 4.5 | 5.5 | B |
| 27 | 7 | 0.1 | - | 4.5 | 5.4 | A/B |

**Table 1 D**

| Example | Dispersant | Amount of Dispersant | Sumitomo Alumina AESIIC | Terpineol diluent | Viscosity |
|---|---|---|---|---|---|
| 1 | - | - | 5 | 5 | B/C |
| 2 | 10 | 0.1 | 5 | 4.9 | B |
| 3 | 9 | 0.1 | 5 | 4.9 | B |

The viscosity of Examples 1-4, 9 - 12, A and B was also measured at 20°C, after removal of the glass beads, using a Thermal Analyser model CSL² 500 equipped with a 4cm cone, 2° face at a 57 µm gap. The results are given in Table 2 below.

**Table 2**

| Example 1 | | | | | | | | | |
|---|---|---|---|---|---|---|---|---|---|
| | Shear rate 1/s | 1.006 | 5.02 | 9.921 | 20.37 | 52.44 | 107.6 | 506.7 | 1000 |
| | Viscosity (Pa.s) | 7.797 | 2.141 | 1.35 | 0.8715 | 0.539 | 0.4048 | 0.2566 | 0.2404 |

| Example 2 | | | | | | | | | |
|---|---|---|---|---|---|---|---|---|---|
| | Shear rate 1/s | 0.9132 | 4.994 | 10.24 | 21.02 | 52.12 | 106.9 | 503.9 | 1033 |
| | Viscosity (Pa.s) | 11.49 | 2.403 | 1.434 | 0.9208 | 0.5958 | 0.4426 | 0.2898 | 0.2552 |

| Example 3 | | | | | | | | | |
|---|---|---|---|---|---|---|---|---|---|
| | Shear rate 1/s | 0.9132 | 4.994 | 10.24 | 21.02 | 52.12 | 106.9 | 503.9 | 1033 |
| | Viscosity (Pa.s) | 11.49 | 2.403 | 1.434 | 0.9208 | 0.5958 | 0.4426 | 0.2898 | 0.2552 |

| Example 4 | | | | | | | | | |
|---|---|---|---|---|---|---|---|---|---|
| | Shear rate 1/s | 0.8835 | 4.976 | 10.22 | 20.96 | 51.94 | 106.6 | 502.3 | 1030 |
| | Viscosity (Pa.s) | 11.94 | 2.373 | 1.448 | 0.926 | 0.5995 | 0.4414 | 0.286 | 0.2508 |

| Control A | | | | | | | | | |
|---|---|---|---|---|---|---|---|---|---|
| | Shear rate 1/s | 1.184 | 4.963 | 10.19 | 20.95 | 54.03 | 106.7 | 503.3 | 1032 |
| | Viscosity (Pa.s) | 23.41 | 6.41 | 3.595 | 2.048 | 1.068 | 0.7386 | 0.3688 | 0.3008 |

| Example 9 | | | | | | | | | |
|---|---|---|---|---|---|---|---|---|---|
| | Shear rate 1/s | 1.08 | 4.918 | 10.1 | 20.71 | 53.28 | 109.3 | 495.5 | 1016 |
| | Viscosity (Pa.s) | 0.3766 | 0.3732 | 0.3376 | 0.3298 | 0.2932 | 0.273 | 0.2623 | 0.2507 |

| Example 10 | | | | | | | | | |
|---|---|---|---|---|---|---|---|---|---|
| | Shear rate 1/s | 1.018 | 4.839 | 9.864 | 20.28 | 52.53 | 108.1 | 490.9 | 1008 |
| | Viscosity (Pa.s) | 4.749 | 3.251 | 3.218 | 3.036 | 2.316 | 1.741 | 0.9097 | 0.6764 |

| Example 11 | | | | | | | | | |
|---|---|---|---|---|---|---|---|---|---|
| | Shear rate 1/s | 1.077 | 5.031 | 9.947 | 20.41 | 52.5 | 107.7 | 507 | 1001 |
| | Viscosity (Pa.s) | 0.2944 | 0.3455 | 0.3585 | 0.331 | 0.3106 | 0.2907 | 0.2702 | 0.2655 |

| Example 12 | | | | | | | | | |
|---|---|---|---|---|---|---|---|---|---|
| | Shear rate 1/s | 1.067 | 5.042 | 9.952 | 20.4 | 52.5 | 107.7 | 507.4 | 1002 |
| | Viscosity (Pa.s) | 0.2516 | 0.2419 | 0.2376 | 0.2293 | 0.2136 | 0.2001 | 0.1872 | 0.1854 |

| Control B | | | | | | | | | |
|---|---|---|---|---|---|---|---|---|---|
| | Shear rate 1/s | 1.077 | 5.54 | 10.17 | 20.13 | 51.88 | 106.5 | 502.6 | 1031 |
| | Viscosity (Pa.s) | 21.62 | 7.663 | 4.677 | 2.763 | 1.386 | 0.8579 | 0.3709 | 0.2773 |

If a polymer is described with a molecular weight without specifying number average or weight average, it should be interpreted as number average.

## Claims

1. The use of a dispersion comprising an electronic particulate solid, a carrier and a dispersant of formula (1)
R - (O - A - CO)ₓ (O - B -CO)_{y} - Z (1)
wherein
R is hydrogen or a polymerisation terminating group;
A is C₈₋₂₀-alkylene and/or C₈₋₂₀-alkenylene;
B is C₁₋₆-alkylene or a lactone thereof;
Z is the residue of a polyamine or polyimine;
x is from 2 to 45;
y is from 0 to 15; and
the ratio of x : y is not less than 3:1,
in the manufacture of a multi-layer ceramic capacitor.

2. The use as claimed in claim 1 wherein R is C₁₋₅₀-alkyl which may be linear or branched.

3. The use as claimed in either claim 1 or claim 2 wherein (O - A - CO) is the residue of ricinoleic acid.

4. The use as claimed in any one of claims 1 to 3 wherein y is 0.

5. The use as claimed in any one of claims 1 to 4 wherein the weight ratio of R - (O - A - CO)ₓ (O - B - CO)_{y} - to Z is from 8 to 15.

6. The use as claimed in claim 1 wherein the polyimine or polyamine is polyallylamine, polyvinylamine or poly(C₂₋₄-alkylene imine).

7. The use as claimed in claim 6 wherein the poly(C₂₋₄-alkylene imine) is polyethylene imine.

8. The use as claimed in any one of claims 1 to 5 wherein the dispersant is represented by formula (2) 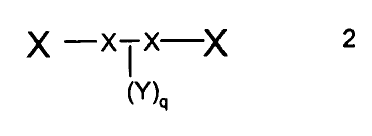 wherein
X - x - x - X represents the polyamine or polyimine;
Y represents the polyester chain moiety R-(O - A - CO)ₓ (O - B - CO)_{y} - ; and
q is from 4 to 2,000 and wherein said electronic particulate solid comprises a dielectric solid or a conduction solid or mixtures thereof.

## Patentansprüche

1. Verwendung einer Dispersion, die einen elektronischen teilchenförmigen Feststoff, einen Träger und ein Dispergiermittel der Formel (1)
R-(O-_{A}-CO)ₓ(O-B-CO)_{y}-Z (1)
umfasst, wobei
R Wasserstoff oder eine polymerisationsabbrechende Gruppe ist;
A = C₈₋₂₀-Alkylen und/oder C₈₋₂₀-Alkenylen ist;
B = C₁₋₆-Alkylen oder ein Lacton davon ist;
Z der Rest eines Polyamins oder Polyimins ist;
x = 2 bis 45 beträgt;
y = 0 bis 15 beträgt; und
das Verhältnis von x : y nicht kleiner als 3:1 ist;
bei der Herstellung eines mehrschichtigen Keramikkondensators.

2. Verwendung gemäß Anspruch 1, wobei R = C₁₋₅₀-Alkyl ist, das linear oder verzweigt sein kann.

3. Verwendung gemäß Anspruch 1 oder 2, wobei (O-A-CO) der Rest von Ricinolsäure ist.

4. Verwendung gemäß einem der Ansprüche 1 bis 3, wobei y = 0 ist.

5. Verwendung gemäß einem der Ansprüche 1 bis 4, wobei das Gewichtsverhältnis von R-(O-A-CO)ₓ(O-B-CO)_{y}- zu Z 8 bis 15 beträgt.

6. Verwendung gemäß Anspruch 1, wobei es sich bei dem Polyimin oder Polyamin um Polyallylamin, Polyvinylamin oder Poly(C₂₋₄-alkylenimin) handelt.

7. Verwendung gemäß Anspruch 6, wobei es sich bei dem Poly(C₂₋₄-alkylenimin) um Polyethylenimin handelt.

8. Verwendung gemäß einem der Ansprüche 1 bis 5, wobei das Dispergiermittel durch Formel (2) 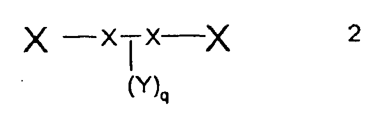 dargestellt wird, wobei
X-x-x-X das Polyamin oder Polyimin darstellt;
Y die Polyesterketten-Struktureinheit R-(O-A-CO)ₓ(O-B-CO)_{y}- darstellt; und
q = 4 bis 2000 beträgt und wobei der elektronische teilchenförmige Feststoff einen dielektrischen Feststoff oder einen leitfähigen Feststoff oder Gemische davon umfasst.

## Revendications

1. Utilisation d'une dispersion comprenant un solide particulaire électronique, un support et un dispersant de formule (1)
R - (O - A - CO)ₓ (O - B - CO)_{y} - Z (1)
dans laquelle
R est un hydrogène ou un groupe de terminaison de polymérisation ;
A est un alkylène en C₈ à C₂₀ et/ou un alcénylène en C₈ à ₂₀ ;
B est un alkylène en C₁ à C₆ ou une lactone de celui-ci ;
Z est le résidu d'une polyamine ou d'une polyimine ;
x est 2 à 45 ;
y est 0 à 15 ; et
le rapport x : y n'est pas inférieur à 3 : 1,
dans la fabrication d'un condensateur multicouche en céramique.

2. Utilisation selon la revendication 1, dans laquelle R est un alkyle en C₁ à C₅₀ qui peut être linéaire ou ramifié.

3. Utilisation selon la revendication 1 ou la revendication 2, dans laquelle (O-A-CO) est le résidu de l'acide ricinoléique.

4. Utilisation selon l'une quelconque des revendications 1 à 3, dans laquelle y est 0.

5. Utilisation selon l'une quelconque des revendications 1 à 4, dans laquelle le rapport pondéral de R-(O-A-CO)ₓ(O-B-CO)_{y}- sur Z est de 8 à 15.

6. Utilisation selon la revendication 1, dans laquelle la polyimine ou la polyamine est la polyallylamine, la polyvinylamine ou une poly((alkylène en C₂ à C₄)imine).

7. Utilisation selon la revendication 6, dans laquelle la poly((alkylène en C₂ à C₄)imine) est la polyéthylène imine.

8. Utilisation selon l'une quelconque des revendications 1 à 5, dans laquelle le dispersant est représenté par la formule (2) 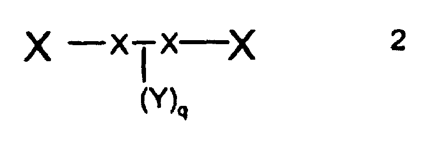 dans laquelle
X-x-x-X représente la polyamine ou la polyimine ;
Y représente le fragment de chaîne de polyester R-(O-A-CO)ₓ(O-B-CO)_{y}- ; et
q est 4 à 2 000 et dans laquelle ledit solide particulaire électronique comprend un solide diélectrique ou un solide conducteur, ou leurs mélanges.
